**Europäisches Patentamt**

**European Patent Office**

**Office européen des brevets**

(19)

(11) Publication number : **0 235 156 B2**

# (12) NEW EUROPEAN PATENT SPECIFICATION

(45) Date of publication of the new patent specification : **29.04.92 Bulletin 92/18**

(51) Int. Cl.⁵ : **B60R 16/02, H03K 17/94**

(21) Application number : **86900531.4**

(22) Date of filing : **19.12.85**

(86) International application number :
**PCT/US85/02518**

(87) International publication number :
**WO 87/01343 12.03.87 Gazette 87/06**

(54) **OPTICAL SEAT SWITCH.**

(30) Priority : **05.09.85 US 773142**

(43) Date of publication of application :
**09.09.87 Bulletin 87/37**

(45) Publication of the grant of the patent :
**08.03.89 Bulletin 89/10**

(45) Mention of the opposition decision :
**29.04.92 Bulletin 92/18**

(84) Designated Contracting States :
**DE FR GB IT**

(56) References cited :
**DE-A- 2 256 930**

(56) References cited :
**DE-A- 3 118 838**
**DE-A- 3 123 829**
**DE-A- 3 147 576**
**FR-A- 2 088 557**
**Patent Abstracts of Japan, volume 7, no. 266 (P-239) (1411) 26 November 1983**

(73) Proprietor : **CATERPILLAR INDUSTRIAL INC.**
**5960 Heisley Road**
**Mentor Ohio 44060 (US)**

(72) Inventor : **TUPMAN, David, J.**
**3-6 Meadowlawn Drive**
**Mentor, OH 44060 (US)**

(74) Representative : **Jackson, Peter Arthur et al**
**Gill Jennings & Every, 53-64 Chancery Lane**
**London WC2A 1HN (GB)**

EP 0 235 156 B2

## Description

This invention relates to an apparatus and method for producing a control signal in response to the presence and absence of an occupant in the seat of the vehicle.

For a variety of reasons, it is often necessary to detect the presence and absence of an occupant in the seat of a vehicle. For example, in the case of an industrial vehicle such as a lift truck, it is common practice to disable the lift truck operating system except when an operator is sitting in the lift truch seat.

Various methods of sensing the presence and absence of an occupant in the seat of a vehicle have been proposed in the past. In the simplest designs, a mechanical switch is embedded in the seat cushion, or is otherwise mechanically linked to motion of the seat. The mechanical switch produces a signal in response to a predetermined amount of weight placed on the vehicle seat. In a more complex arrangenent, US-A-3 764 861 discloses an electronic detection device. A capacitive switch is placed within the cushion of a vehicle seat, and produces a signal in response to a sensed shift in capacitance caused by the presence of an object on the vehicle seat.

Although various seat switches, such as those described above, have been proposed in the past, none have been found to be fully satisfactory. Such prior seat switches are subject to damage, especially owing to repetitive flexing of the sensing elments caused by the weight of the occupant of the vehicle seat, and exacerbated by vibration of the vehicle. In the case of electronic sensors, many are excessively complex and subject to failure when operated in an industrial environment. Additionally, most sensing devices located within or attached to the vehicle seat can be inadvertently operated by placing an object on the seat which is of sufficient mass to trigger the sensing mechanism.

US-A-4388527 and DE-A-2256930 disclose apparatus for producing a control signal in response to the presence and absence of an object, the apparatus including an emitting means for directing a source of coded radiant energy and a detecting means for receiving at least a portion of the coded radiant energy and producing an electrical signal in response to the received radiant energy.

In accordance with the invention, such apparatus is characterized in that the apparatus is mounted in a vehicle having a seat; in that the emitting means is arranged to direct the coded radiant energy obliquely across the vehicle seat by virtue of one of the emitting and detecting means being located at the rear of the seat and above the level of a back of the seat, and the other of the emitting and detecting means being located in front of and below the level of the seat, whereby the detecting means is arranged to receive radiant energy, including a portion of the coded radiant energy in response to the seat being vacant; and by discriminating means for distinguishing the electrical signal produced in response to the detecting means receiving the coded radiant energy, from electrical signals produced in response to the detecting means receiving spurious uncoded radiant energy; and circuit means for producing the control signal only in response to the detecting means receiving the coded radiant energy.

The invention also includes a method for sensing the presence and absence of an object and producing a control signal in response to the presence and absence of such object, the method comprising directing a source of coded radiant energy and receiving radiant energy including a portion of the coded radiant energy in response to the object being absent; producing an electrical signal in response to receiving the radiant energy; and producing a control signal in response to receiving the coded radiant energy; (as disclosed in US-A-4388527 and DE-A-2256930) characterized in that the object is an occupant in a seat of a vehicle; in that the coded radiant energy is directed obliquely across the seat from or to a position at the rear of the seat and above the level of a back of the seat, respectively to or from a position in front of and below the level of the seat; and by distinguising the electrical signal produced in response to receiving the coded radiant energy, from electrical signals produced in response to receiving spurious uncoded radiant energy.

In the accompanying drawings:-
Fig. 1 is a side elevational view of a vehicle incorporating the one embodiment of the present invention;
Fig. 2 is a block diagram of an embodiment of the present invention;
Fig. 3 is a detailed schematic diagram of the embodiment of the invention illustrated in Fig. 2;
Fig. 4 illustrates waveforms associated with the embodiment of Fig. 2 when the vehicle seat is unoccupied; and,
Fig. 5 illustrates waveforms associated with the embodiment of Fig. 2 when the vehicle seat is occupied.

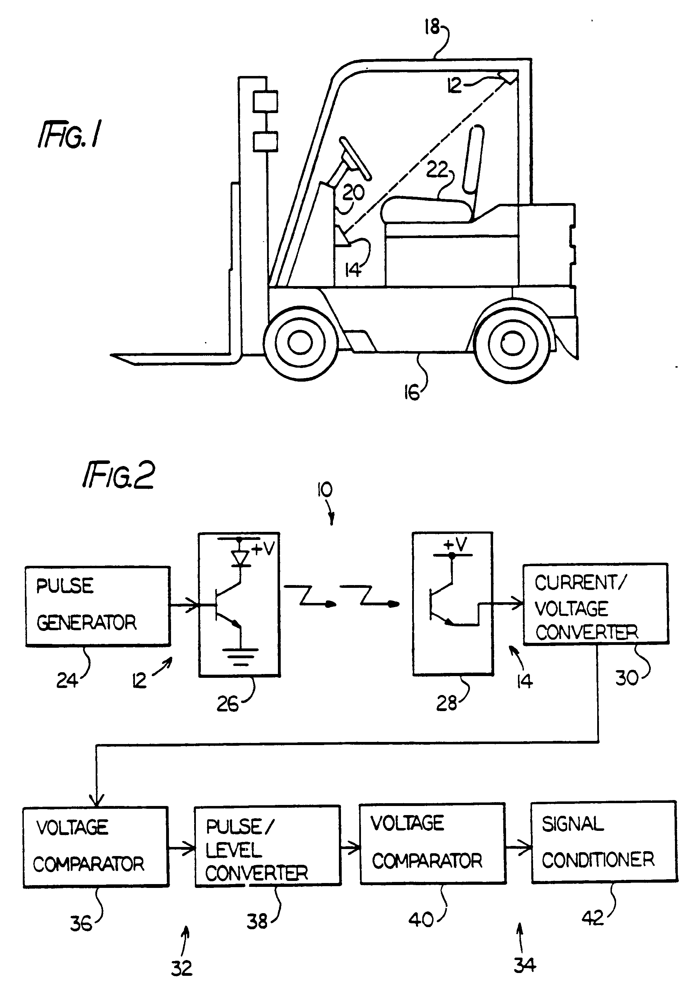

Referring first to Fig. 2, an apparatus embodying certain of the principles of the present invention is generally indicated by the reference numeral 10. It should be understood that the following detailed description relates to the best presently known embodiment of the apparatus 10. However, the apparatus 10 can assume numerous other embodiments, as will become apparent to those skilled in the art, without departing from the appended claims.

The apparatus 10 includes emitting means 12 and detecting means 14. Referring temporarily to Fig. 1, a vehicle 16, for example, an industrial vehicle such as a lift truck having an overhead guard 18, a steering console 20, and a vehicle seat 22, includes the emitting means 12 and the detecting means 14. The emitting means 12 is attached to the overhead guard 18 and positioned to direct a source of coded radiant energy across the vehicle seat 22. The detecting means 14 is attached to the console 20 and positioned to receive radiant energy, including a portion of the coded radiant energy from the emitting means 12 so long as a line of sight is available between the emitting means 12 and the detecting means 14. In other words, so long as the vehicle seat 22 is unoccupied, the emitting means 12 and detecting means 14 are in optical communication with one another. It is recognized that reversal of the position of the emitting and detecting means is of no particular significance in the arrangement shown in Fig. 1.

Adverting now to Fig. 2, the emitting means 12 includes a pulse generator means 24 for substantially continuously producing a series of current pulses having a predetermined frequency and duty cycle, and an infrared light emitting diode 26 connected to the pulse generator means 24 and adapted to produce radiant energy having a wave length substantially within the infrared spectrum, in response to receiving each of the produced current pulses.

The detector means 14 includes a phototransistor 28 adapted to produce a current signal in response to receiving radiant energy, and a current-to-voltage converter means 30 for receiving the current signal from the phototransistor 28 and responsively producing a voltage signal. The current-to-voltage converter means 30 is connected to the phototransistor 28.

The apparatus 10 includes discriminating means 32 for distinguishing the electrical signal produced in response to the detecting means 14 receiving the coded radiant energy, from electrical signals produced in response to the detecting means 14 receiving spurious uncoded radiant energy, and circuit means 34 for producing a control signal only in response to the detecting means 14 receiving the coded radiant energy. The discriminating means 32 includes a first voltage comparator means 36 for receiving the voltage signal, comparing the voltage signal with a first predetermined voltage reference signal, and producing a comparison signal in response to the voltage signal having a magnitude exceeding the magnitude of the first predetermined voltage reference signal. The discriminating means 32 also includes a pulse-to-level converter means 38 for receiving the comparison signal and producing a voltage level signal in response to the received comparison signal.

The circuit means 34 includes a second voltage comparator means 40 for receiving the voltage level signal, comparing the voltage level signal with a second predetermined voltage reference signal, and producing the control signal in response to the voltage level signal having a magnitude exceeding the magnitude of the second predetermined voltage reference signal. The control signal is delivered by the second voltage comparator means 40 to a signal conditioner circuit 42.

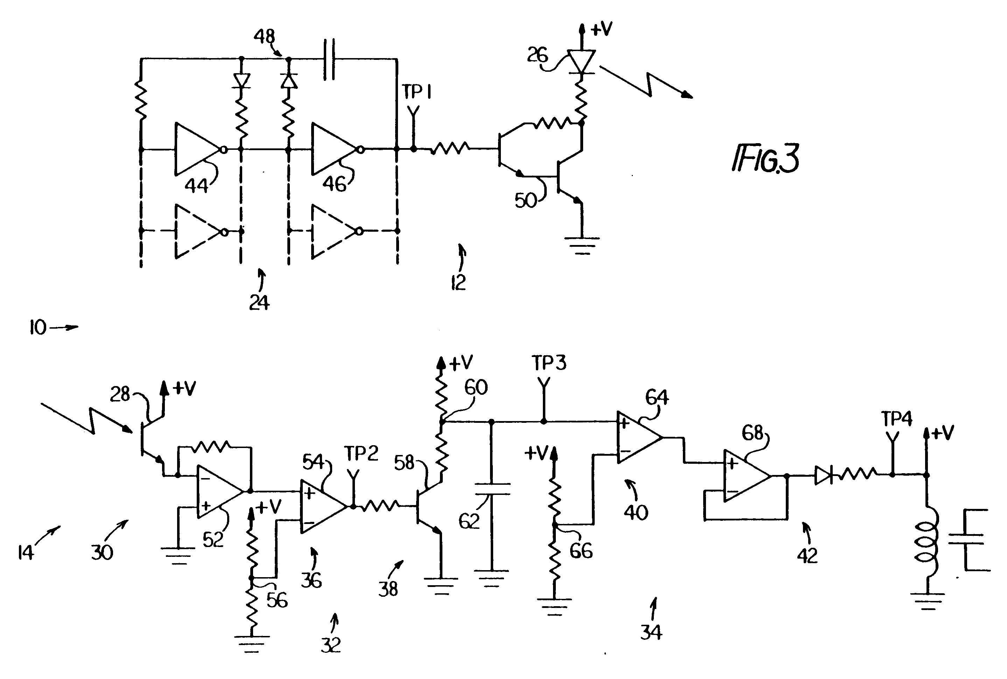

Fig. 3 illustrates a schematic diagram of an embodiment of the block diagram of Fig. 2. The emitting means 12 includes the pulse generator means 24. The pulse generator means 24 can be a conventional pulse generating arrangement, for example, a simple astable multivibrator composed of a pair of inverters 44, 46 connected with a suitable feedback arrangement 48 to provide square wave pulses at TP1 at a desired frequency, for example, 100 Hertz. The current pulses are delivered to a transistor driver 50 which is serially connected with the light emitting diode 26 between supply voltage and circuit ground.

The detecting means 14 includes the phototransistor 28 connected between supply voltage and the inverting input terminal of an amplifier 52. The phototransistor 28 produces a current signal in response to the magnitude of radiant energy received. The amplifier 52 and associated components collectively comprise the current-to-voltage converter means 30 which produces a voltage signal responsive to the current signal delivered at the inverting input terminal of the amplifier 52.

This current signal is delivered from the amplifier 52 to a first input terminal of the first voltage comparator means 36. The first voltage comparator means 36 includes a comparator 54 and a voltage divider 56. The voltage divider 56 is connected to a second input terminal of the first voltage comparator means 36. An output terminal of the comparator 54 is connected to a transistor 58, which forms part of the pulse-to-level converter means 38. The transistor 58 is serially connected through a pair of resistors 60 between supply voltage and circuit ground. The junction of the pair of resistors 60 is connected through a capacitor 62 to circuit ground, and to a first input terminal of the second voltage comparator means 40.

The second voltage comparator means 40 includes a comparator 64 having a second input terminal connected to a voltage divider 66, and an output terminal connected to the signal conditioner circuit 42. The signal conditioner circuit 42 includes a buffer amplifier 68 and an output terminal TP4.

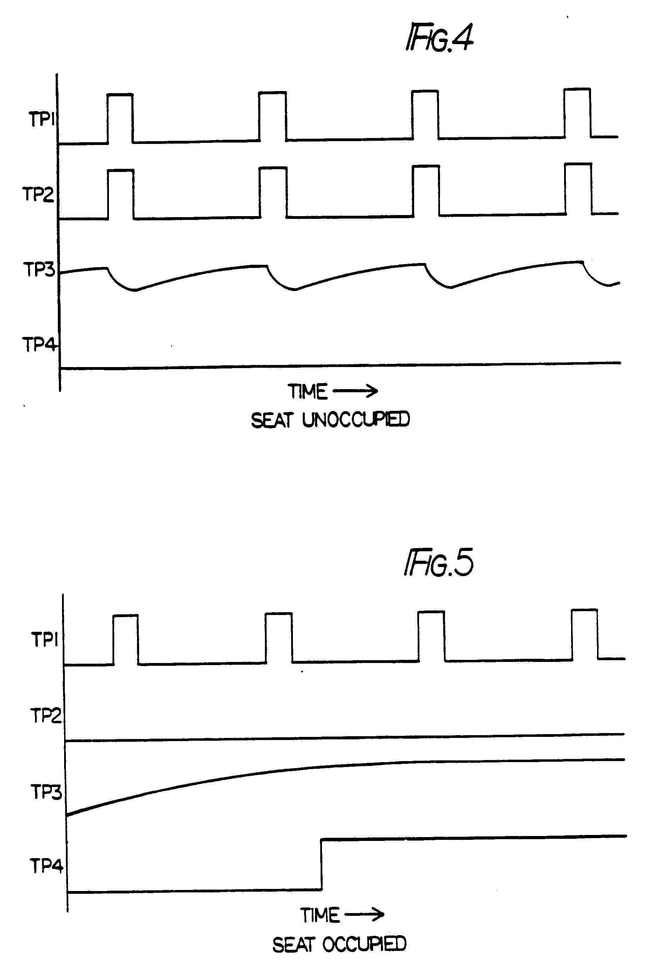

Operation of the apparatus 10 is best described in relation to its use on a vehicle 16, for example, an industrial vehicle such as an electric lift truck. During the following discussion, reference can be made to the waveforms in Figs. 4 and 5 as they relate to the various test points shown in Fig. 3.

Assuming first that the vehicle seat 22 is unoccupied, and that at least a portion of the coded radiant energy delivered from the emitting means 12 is received by the detecting means 14, the waveforms of Fig. 4 are applicable to the following discussion. The pulse generator means 24 substantially continuously produces the series of current pulses shown at TP1, having a predetermined frequency and duty cycle. This series of pulses is produced so long as supply voltage is connected to the apparatus 10. Each current pulse causes the transistor driver 50 to turn "on" momentarily, producing a corresponding pulse of radiant energy from the light emitting diode 26.

Owing to the fact that the seat 22 is unoccupied, the phototransistor 28 receives the coded radiant energy from the light emitting diode 26, as well as spurious, uncoded radiant energy resulting from ambient lighting conditions. The phototransistor 28 responsively delivers a current signal to the associated amplifier 52, which produces a voltage signal at the first input terminal of the first comparator means 36. The magnitude of the voltage signal produced by the amplifier 52 is responsive to the magnitude of radiant energy received by the phototransistor 28. The first comparator means 36 compares the voltage signal delivered by the amplifier 52 with the first predetermined voltage reference signal delivered by the voltage divider 56, and responsively delivers the waveform shown at TP2 to the transistor 58. The first predetermined voltage reference signal level delivered from the voltage divider 56 is selected to prevent the first comparator means 36 from producing an output signal at TP2 in response to ambient lighting conditions, and to allow the first comparator means 36 to produce an output signal at TP2 in response to the phototransistor 28 receiving the coded radiant energy.

Each voltage pulse at TP2 causes the transistor 58 to turn "on" for the duration of the pulse, thereby discharging the capacitor 62 through the transistor 58 and the associated series resistor. When the transistor 58 is turned "off", the capacitor 62 charges from the supply voltage through the associated series resistor. The charge/discharge cycle of the capacitor 62 is shown at TP3. The instantaneous voltage present on the capacitor 62 is delivered to one input terminal of the second comparator means 40, and the magnitude of this voltage is compared with the second predetermined voltage reference signal delivered to the other input terminal of the second comparator means 40 by the voltage divider 66.

Owing to the fact that the pulses received by the transistor 58 occur at regular frequent intervals, the capacitor 62 fails to charge to a voltage level sufficient to exceed the second predetermined reference voltage level from the voltage divider 66, and the output of the comparator 64 remains at a logic "0" state. This logic signal is coupled through the signal conditioner circuit 42 as shown at TP4.

For illustrative purposes, the output of the signal conditioner 42 is shown driving the coil of a relay 70. The relay 70 is part of the vehicle control circuitry and can perform whatever function is desired, for example, turning "off" the vehicle motors, engaging the vehicle brakes, etc. Alternatively, the output of the signal conditioner 42 can connect directly to a vehicle control computer or other associated device. The use to which the control signal is put in a particular instance is not part of the claimed invention.

Referring now to the waveforms of Fig. 5, in response to the vehicle seat 22 being occupied, optical communication between the emitting means 12 and detecting means 14 is interrupted by the body of the vehicle operator. Consequently, even though the light emitting diode 26 continues to produce the coded radiant energy pulses responsive to the current pulses at TP1, the coded pulses are not received by the phototransistor 28.

The amplifier 52 delivers an electrical voltage signal that is of relatively low magnitude to the first comparator means 36. The voltage signal delivered is representative only of a relatively small amount of ambient light that is received by the phototransistor 28. Responsively, the output of the comparator 54 is a logic "0" signal, as shown at TP2. Owing to the fact that the logic "0" signal at TP2 is continuous, the transistor 58 remains "off" and the capacitor 62 slowly charges to supply voltage through the associated series resistor, as shown at TP3 in Fig. 5.

Once the capacitor 62 charges to a voltage level which exceeds the magnitude of the second predetermined voltage reference signal delivered to the second comparator means 40 by the voltage divider 66, the output of the comparator 64 switches from a logic "0" to a logic "1" state, as is reflected by the control signal delivered at TP4 from the signal conditioner circuit 42. The logic "1" control signal delivered at TP4 indicates that the seat 22 is occupied and can, for example, actuate the relay 70 or be utilized in other known ways by the vehicle controller.

Therefore, the instant invention provides a reliable and inexpensive apparatus for electronically monitoring the presence and absence of an occupant in the seat 22 of a vehicle 16, while avoiding many of the problems associated with prior art devices. The presence of a box or other object on the seat 22 will not cause the apparatus 10 to be mislead into producing the occupied seat control signal unless the object is so large as to extend above the seat 22 sufficiently to bloch optical communication between the emitting means 12 and detecting means 14.

## Claims

1. Apparatus (10) for producing a control signal in response to the presence and absence of an object, the apparatus including an emitting means (12) for directing a source of coded radiant energy and a detecting means (14) for receiving at least a portion of the coded radiant energy and producing an electrical signal in response to the received radiant energy, characterized in that the apparatus is mounted in a vehicle (16) having a seat (22); in that the emitting means (12) is arranged to direct the coded radiant energy obliquely across the vehicle seat (22) by virtue of one of the emitting and detecting means (12,14) being located at the rear of the seat and above the level of a back of the seat (22), and the other of the emitting and detecting means (12,14) being located in front of and below the level of the seat (22), whereby the detecting means (14) is arranged to receive radiant energy, including a portion of the coded radiant energy in response to the seat (22) being vacant; and by discriminating means (32) for distinguishing the electrical signal produced in response to the detecting means (14) receiving the coded radiant energy, from electrical signals produced in response to the detecting means (14) receiving spurious uncoded radiant energy; and circuit means (34) for producing the control signal only in response to the detecting means (14) receiving the coded radiant energy.

2. Apparatus (10) according to claim 1, wherein the emitting means (12) includes pulse generator means (24) for substantially continuously producing a series of current pulses having a predetermined frequency and duty cycle, and an infrared light emitting diode (26) connected to the pulse generator means (24) and adapted to produce radiant energy having a wavelength substantially within the infrared spectrum, in response to receiving each of the current pulses.

3. Apparatus (10) according to claim 1 or claim 2, wherein the detecting means (14) includes a phototransistor (28) adapted to produce a current signal in response to receiving radiant energy, and current to voltage converter means (30) for receiving the current signal from the phototransistor (28) and responsively producing a voltage signal, the current to voltage converter means (30) being connected to the phototransistor (28).

4. Apparatus (10) according to claim 3, wherein the discriminating means (32) includes first voltage comparator means (36) for receiving the voltage signal, comparing the voltage signal with a first predetermined voltage reference signal, and producing a comparison signal in response to the voltage signal having a magnitude exceeding the magnitude of said first predetermined voltage reference signal, and pulse to level converter means (38) for receiving the comparison signal and producing a voltage level signal in response to the received comparison signal.

5. Apparatus (10) according to claim 4, wherein the circuit means (34) includes second voltage comparator means (40) for receiving the voltage level signal, comparing the voltage level signal with a second predetermined voltage reference signal, and producing a control signal in response to the voltage level signal having a magnitude exceeding the magnitude of the second predetermined voltage reference signal.

6. A method for sensing the presence and absence of an object and producing a control signal in response to the presence and absence of such object, the method comprising directing a source of coded radiant energy and receiving radiant energy including a portion of the coded radiant energy in response to the object being absent; producing an electrical signal in response to receiving the radiant energy; and producing a control signal in response to receiving the coded radiant energy; characterized in that the object is an occupant in a seat (22) of a vehicle (16); in that the coded radiant energy is directed obliquely across the seat from or to a position at the rear of the seat and above the level of a back of the seat, respectively to or from a position in front of and below the level of the seat; and by distinguising the electrical signal produced in response to receiving the coded radiant energy, from electrical signals produced in response to receiving spurious uncoded radiant energy.

**Patentansprüche**

1. Vorrichtung (10) zur Erzeugung eines Steuersignals infolge des Vorhandenseins und Nichtvorhandenseins eines Objekts, wobie die Vorrichtung folgendes aufweist: Emmittiermittel (12) zur Leitung einer Quelle kodierter Strahlungsenergie und Detektiermittel (14) zum Empfang von mindestens einem Teil der kodierten Strahlungsenergie und zur Erzeugung eines elektrischen Signals infolge der empfangenen Strahlungsenergie, dadurch gekennzeichnet, daß die Vorichtung in einem Fahrzeug (16) angeordnet ist mit einem Sitz (22), daß die Emmitiermittel (12) so angeordnet sind, daß sie die kodierte Strahlungsenergie schräg über den Fahrzeugsitz (22) leiten, und zwar dadurch, daß eines der Emmitier- und Detektiermittel (12, 14) und der Rückseite des Sitzes und oberhalb des Niveaus eines Hinterteils des Sitzes (22) angeordnet ist, und daß das andere der Emmitier- und Detektiermittel (12, 14) vor und unterhalb des Niveaus des Sitzes (22) angeordnet ist, wodurch die Detektiermittel (14) derart angeordnet sind, daß sie Strahlungsenergie empfangen, einschließlich eines Teils der kodierten Strahlungsenergie infolge des leer seienden Sitzes (22); und daß Diskriminiermittel (32) vorgesehen sind, um das elektrische Signal, welches infolge des Empfangs kodierter Strahlungsenergie durch die Detektiermittel (14) erzeugt wird von den elektrischen Signalen zu unterscheiden, die erzeugt werden infolge des Empfangs von spurenförmiger nicht kodierter Strahlungsenergie; und ferner gekennzeichnet durch Schaltungsmittel (34) zur Erzeugung des Steuersignals nur infolge des Empfangs der kodierten Strahlungsenergie durch die Detektiermittel (14).

2. Vorrichtung (10) nach Anspruch 1, wobei die Emmittiermittel (12) Pulsgeneratormittel (24) aufweisen, um im wesentlichen kontinuierlich eine Reihe von Stromimpulsen zu erzeugen mit einer vorbestimmten Frequenz und Tastzeit, und daß eine Infrarotlicht emmittierende Diode (26) mit den Impulsgeneratormitteln (24) verbunden ist und geignet ist zur Erzeugung von Strahlungsenergie mit einer Wellenlänge im wesentlichen innerhalb des Infrarotspektrums infolge des Empfangs jedes der Stromimpulse.

3. Vorrichtuny (10) nach Anspruch 1 oder 2, wobei die Detektiermittel (14) einen Fototransistor (28) aufweisen geeignet zur Erzeugung eines Stromsignals infolge des Empfangs von Strahlungsenergie, und wobei ferner Strom-zu-Spannungsumwandlermittel (30) vorgesehen sind, um das Stromsignal vom Fototransistor (28) zu empfangen und in darauf ansprechender Weise ein Spannungssignal zu erzeugen, wobei die Strom-zu-Spannungsumwandlermittel (30) mit dem Fototransistor (28) verbunden sind.

4. Vorrichtung (10) nach Anspruch 3, wobei die Diskriminiermittel (32) erste Spannungsvergleichssmittel (36) aufweisen zum Empfang des Spanungssignals, zum Vergleich des Spannungssignals mit einem ersten vorbestimmten Spannungsbezugssignal, und zur Erzeugung eines Vergleichssignals infolge der Tatsache, daß das Spannungssignal eine Größe besitzt, die die Größe des ersten vorbestimmten Spannungsbezugssignals übersteigt, und Impuls-zu-Pegelumwandlermittel (38) zum Empfang des Vergleichssignals und zur Erzeugung eines Spannungspegelsignals infolge des empfangenen VergleichsSignals.

5. Vorrichtung (10) nach Anspruch 4, wobei die Schaltungsmittel (34) zweite Spannungsvergleichssmittel (40) aufweisen zum Empfang des Spannungspegelsignals, zum Vergleich des Spannungspegelsignals mit einem zweiten vorbestimmten Spannungsbezugssignals und zur Erzeugung eines Steuersignals infolge der Tatsache, daß das Spannungspegelsignal eine Größe besitzt, die die Größe des zweiten vorbestimmten Spannungsbezugssignals übersteigt.

6. Verfahren zum Abfühlen des Vorhandenseins und Nichtvorhandenseins eines Objekts und zur Erzeugung eines Steuersignals infolge des Vorhandenseins und Nichtvorhandenseins eines solchen Objekts, wobei das Verfahren folgendes aufweist: Leitung einer Quelle kodierter Strahlungsenergie und Empfang von Strahlungsenergie einschließlich eines Teils der kodierten Strahlungsenergie infolge der Tatsache, daß das Objekt nicht anwesend ist; Erzeugung eines elektrischen Signals infolge des Empfangs der Strahlungsenergie; und Erzeugung eines Steuersignals infolge des Empfangs der kodierten Strahlungsenergie, dadurch gekennzeichnet, daß das Objekt eine in einem Sitz (22) eines Fahrzeugs (16) sitzende Person ist, daß die kodierte Strahlungsenergie schräg über den Sitz geleitet wird, und zwar von oder zu einer Position an der Rückseite des Sitzes und oberhalb des Niveaus eines Hinterteils des Sitzes, in entsprechender Weise zu oder von einer Position vor und unterhalb des Niveaus des Sitzes, und daß eine Unterscheidung getroffen wird hinsichtlich des elektrischen Signals erzeugt infolge des Empfangs der kodierten Strahlungsenerige und hinsichtlich elektrischer Signale erzeugt infolge des Empfangs von spurenförmiger nicht kodierter Strahlungsenergie.

## Revendications

1. Appareil (10) destiné à produire un signal de commande en réponse à la présence et à l'absence d'un objet, et comportant un moyen émetteur (12) pour diriger une source d'énergie de rayonnement codée, et un moyen détecteur (14) pour recevoir au moins une partie de l'énergie de rayonnement codée et pour produire un signal électrique en réponse à l'énergie de rayonnement reçue, caractérisé en ce qu'il est monté dans un véhicule (16) équipé d'un siège (22) ; en ce que le moyen émetteur (12) est conçu pour diriger l'énergie de rayonnement codée obliquement à travers le siège de véhicule (22) grâce au fait que l'un des moyens émetteur et détecteur (12, 14) est situé à l'arrière du siège (22) et au-dessus du niveau d'un dossier de celui-ci, tandis que l'autre est situé devant le siège (22) et au-dessous du niveau de celui-ci, moyennant quoi, le moyen détecteur (14) est conçu pour recevoir une énergie de rayonnement qui comprend une partie de l'énergie de rayonnement codée en réponse au fait que le siège (22) est inoccupée ; et par des moyens discriminateurs (32) pour établir une distinction entre le signal électrique produit en réponse à la réception par le moyen détecteur (14) de l'énergie de rayonnement codée, et des signaux électriques produits en réponse à la réception par le moyen détecteur (14) d'une énergie de rayonnement parasite non codée ; des moyens formant circuits (34) étant prévus pour produire un signal de commande uniquement en réponse à la réception par le moyen détecteur (14) de l'énergie de rayonnement codée.

2. Appareil (10) selon la revendication 1, dans lequel le moyen émetteur (12) comporte un moyen générateur d'impulsions (24) pour produire d'une manière sensiblement continue une série d'impulsions de courant ayant une fréquence et un cycle opératoire prédéterminés, et une diode émettrice de lumière infrarouge (26) reliée au moyen générateur d'impulsions (24) et adaptée pour, en réponse à la réception de chacune des impulsions de courant, produire une énergie de rayonnement possédant une longueur d'ondes sensiblement dans les limites du spectre d'absorption infrarouge.

3. Appareil (10) selon la revendication 1 ou la revendication 2, dans lequel le moyen détecteur (14) comporte un phototransistor (28) adapté pour produire un signal de courant en réponse à la réception d'une énergie de rayonnement, et un moyen convertisseur courant-tension (30) pour recevoir le signal de courant provenant du phototransistor (28) et pour, en réponse, produire un signal de tension, le moyen convertisseur de courant-tension (30) étant relié au phototransistor (28).

4. Appareil (10) selon la revendication 3, dans lequel les moyens discriminateurs (32) comportent un premier moyen comparateur de tension (36) pour recevoir le signal de tension, pour comparer ce signal de tension avec un premier signal de tension de référence prédéterminé, et pour, en réponse au fait que le signal de tension possède une amplitude supérieure à celle dudit premier signal de tension de référence prédéterminé, produire un signal de comparaison, et un moyen convertisseur impulsion-niveau (38) pour recevoir le signal de comparaison et pour, en réponse au signal de comparaison reçu, produire un signal de niveau de tension.

5. Appareil (10) selon la revendication 4, dans lequel les moyens formant circuit (34) comportent un second moyen comparateur de tension (40) pour recevoir le signal de niveau de tension, pour comparer ce signal de niveau de tension avec un second signal de tension de référence prédéterminé, et pour, en réponse au fait que le signal de niveau de tension possède une amplitude supérieure à celle du second signal de tension de référence prédéterminé, produire une signal de commande.

6. Procédé pour détecter la présence et l'absence d'un objet et pour produire un signal de commande en réponse à la présence et à l'absence dudit objet, comportant les étapes qui consistent à diriger une source d'énergie de rayonnement codée et à recevoir une énergie de rayonnement comprenant une partie de l'énergie de rayonnement codée en réponse à l'absence de l'objet ; à produire un signal électrique en réponse à la réception de l'énergie de rayonnaient ; et à produire un signal de commande en réponse à la réception de l'énergie de rayonnement codée ; caractérisé en ce que l'objet est un passager occupant un siège (22) d'un véhicule (16) ; en ce que l'énergie de rayonnement codée est dirigée obliquement à travers le siège depuis ou vers une position située à l'arrière du siège et au-dessus du niveau d'un dossier de celui-ci, respectivement vers ou depuis une position située devant le siège et au-dessous du niveau de celui-ci ; et en ce qu'il comporte l'étape qui consiste à établir une distinction entre le signal électrique produit en réponse à la réception de l'énergie de rayonnement codée, et des signaux électriques produits en réponse à la réception d'une énergie de rayonnement parasite non codée.

*FIG.1*

*FIG.2*

FIG.3

EP 0 235 156 B2

Fig.4

TP1

TP2

TP3

TP4

TIME ⟶

SEAT UNOCCUPIED

Fig.5

TP1

TP2

TP3

TP4

TIME ⟶

SEAT OCCUPIED